(19) Europäisches Patentamt

European Patent Office

Office européen des brevets

(11) Publication number: **0 029 304**
A2

(12) EUROPEAN PATENT APPLICATION

(21) Application number: **80303733.2**

(22) Date of filing: **22.10.80**

(51) Int. Cl.³: **G 11 C 19/08**

(30) Priority: **20.11.79 US 96099**

(43) Date of publication of application: **27.05.81**
**Bulletin 81/21**

(84) Designated Contracting States: **DE FR GB**

(71) Applicant: **CONTROL DATA CORPORATION, 8100-34th Avenue South, Minneapolis Minnesota 55440 (US)**

(72) Inventor: **Toth, Dolan Harold, 74 East Golden Lake Road, Circle Pines Minnesota 55014 (US)**

(74) Representative: **Caro, William Egerton et al, J. MILLER & CO. Lincoln House 296-302 High Holborn, London WC1V 7JH (GB)**

(54) Bubble memory device.

㊾ A bubble memory device of the word organised, fault tolerant type comprises a number of bubble memory chips (12–26) equivalent in number to a given word size, a correction bit bubble memory chip (28), a Programmable Read Only Memory (74) responsive to input addresses for identifying defective bit locations in the bubble memory chips, an address register (70) providing addresses to the PROM (74) and a decoder (78) substituting, in reading and writing operations, correction bits from the correction bit bubble memory chip (28) for bits in any one of the bubble memory chips in response to output signals from the PROM (74) identifying a defective bit location.

EP 0 029 304 A2

- 1 -

"BUBBLE MEMORY DEVICE"

This invention relates to bubble memory devices and in particular to fault tolerance bubble memory devices.

Herein a "byte" is defined as eight bits. A "word" can be any arbitrary number of bits.

In conventional manufacturing processes for bubble memory chips, a certain number of bubble memory chips will be defective. Normal manufacturing control requires a trade-off between manufacturing 100% perfect bubble memory chips and testing after the manufacture to find defective but usable bubble memory chips. Various suggestions have been made to increase the yield of usable bubble memory chips by designing the bubble memory chip in such a way that a number of faults or defects may exist and yet the bubble memory chip is usable in the particular bubble memory device. Many fault tolerant bubble memory devices exist employing both external logic and memory as well as various modifications of the design of a standard bubble memory chip, or combinations of both.

In U.S. Patent Specification No. 3 909 810 extra minor loops are included in each bubble memory chip in a bubble memory device and an external memory source is used together with logic devices to identify faulty minor loops which are to be ignored in favour of usable minor loops. Thus, all of the fault tolerant ability is based on external logic devices combined with the necessity of having bubble memory chips containing an excess number of minor loops.

U.S. Patent Specification No. 3 792 450 discloses a major loop, minor loop bubble memory device having additional minor loops which are used for the purpose of containing a flaw table to identify the minor loop locations which are defective. The device provides for additional complexity to the individual bubble memory chips in that additional connections and read gates are required on the bubble memory chips to allow for independent reading of the minor loop flaw table. Thus, further care in design and construction of the individual bubble memory chips is required to ensure that proper synchronization is maintained between the redundant loops and the remainder of the bubble memory device so that the correct correspondence is maintained and identity between indications of faulty loops and the actual loops which are defective.

According to the present invention there is provided a bubble memory device characterised by comprising: a plurality of bubble memory chips equivalent in number to a given word size; a correction bit bubble memory chip; memory means responsive to input addresses for identifying defective bit locations in said plurality of bubble memory chips; means for providing addresses to said memory means; and substituting means for substituting in reading and writing operations, correction bits from said correction bit bubble memory chip for bits in any one of said plurality of bubble memory chips in response to output signals from said memory means identifying a defective bit location.

Said substituting means may comprise a decoder associated with an output address from the said memory means for identifying a particular one of said plurality of bubble memory chips having

0029304

- 3 -

a defective location and logic gate means which in response to a signal from said decoder connects said correction bit chip with the appropriate input or output of said memory device in reading and writing operations.

Said logic gate means may be composed of AND gates.

Preferably each said AND gate is connected to receive a common data bit input from said correction bit bubble memory chip and a unique input from said decoder for gating said input in response to an enable signal from said decoder further AND gate means being provided for disabling the output from any one of said bubble memory chips in response to an inverted enable signal from said decoder when a bit from said correction bit chip is to be gated. The bubble memory device may include means for disabling said decoder when no correction bit is to be gated.

The invention is illustrated, merely by way of example, in the accompanying drawings, in which:-

Figure 1 is a block schematic diagram of an embodiment of a bubble memory device according to the present invention; and

Figure 2 is a logic chart illustrating the operating of the bubble memory device of Figure 1.

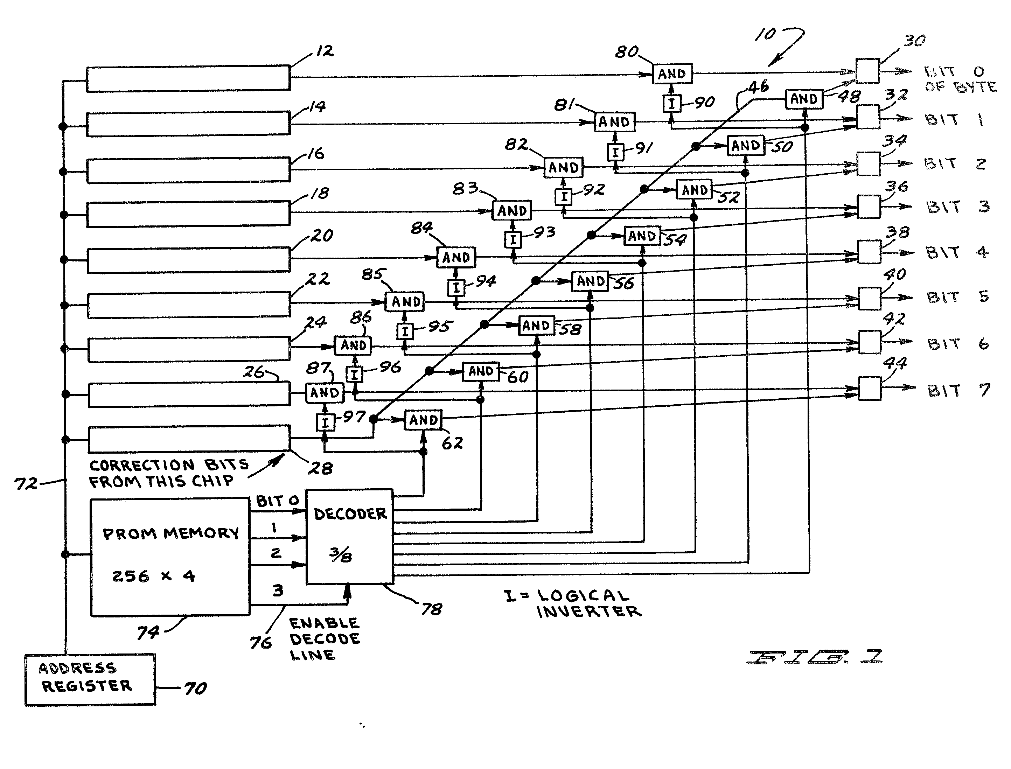

Referring to Figure 1 a bubble memory device according to the present invention is designated by the reference numberal 10 is word organised and fault tolerant. A plurality of bubble memory chips 12, 14, 16, 18, 20, 22, 24, 26 provide individual bit outputs of a byte or word organised memory. By way of example only, Figure 1 shows an 8-bit device in which 8 bubble memory chips are provided with an additional ninth bubble memory chip 28 for the purpose of containing correction bits to be read into and read out of the bubble memory device in place of bits on the bubble memory chips 12 to 26. Any of the nine bubble memory chips may contain defective bits. The output of each of the bubble memory chips 12 to 26 is connected to a bit location in an output register. Bit locations 30, 32, 34, 36, 38, 40, 42, 44 are provided to be associated with bubble memory chips 12 to 26, respectively. The bubble memory chip 28 containing correction bits is connected with a correction bit line 46. The correction bit line 46 provides an input to each of a plurality of AND gates 48, 50, 52, 54, 56, 58, 60, 62. Each of the AND gates 48 to 62 has a data output connected to one of the bit locations 30 to 44, respectively, of the output register. In addition, another path to the output register exists through AND gates 80 to 87 which is the normal path from the bubble memory chips 12 to 26 in the absence of errors.

The bubble memory device 10 receives an input address from an address register 70. The address register 70 provides addresses on an address bus 72 which is connected with each of the bubble memory chips 12 to 28. The address bus 72 also provides an input to a Programmable Read Only Memory (PROM) 74. By way of example in the present embodiment the PROM 74 has a 4-bit output and it may have an address range of 256 addresses. One of the outputs of the PROM 74 is provided on an enable decode line 76 which is connected with a decoder 78. The enable decode line 76 enables the decoder 78, which decodes input bits 0-2 into an enable signal on only one of the eight output lines. The seven remaining decoder output lines are disabled. Hence, the particular enabled AND gate of the AND gates 48 to 62 channels the correction bit to the appropriate bit of the output register. The seven bits which are disabled cause their respective AND gates 80 to 87 to be enabled because of the logical inversion performed by inverters 90 to 97 on the signal from the decoder 78.

When the enable decode line 76 is disabled, all decoder lines are disabled and consequently all AND gates 80 to 87 are enabled causing normal data flow from the bubble memory chips 12 to 26 to the bit locations 30 to 44.

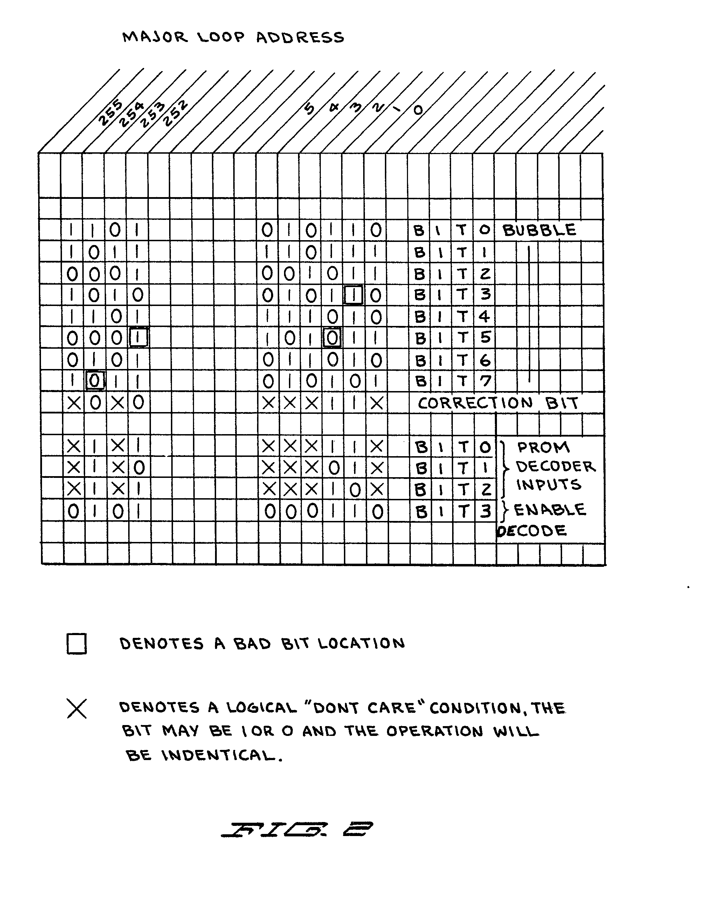

Referring now to Figure 2, an example of the operation and required contents of the PROM 74 is shown with reference to the bubble memory device 10 in order to effect the correction process. Bits corresponding to faulty or bad minor loops are indicated by a square symbol as shown while an X indicates a logical "don't care" condition indicating that the result will be changed regardless of the PROM outputs going to the decoder.

For the purposes of illustration in Figure 2, the major loop addresses in the bubble memory chips assumed to be faulty are 1, 2, 252 and 254. Bit 3 of the PROM 74 contains binary 1's only for these addresses and 0's for all others. The bits in error are (in right-to-left order): 3, 5, 5, 7. This corresponds to bit locations 36, 40, 40, and 44. The first three bits of the PROM 74, namely bits 0-2, contain these faulty bit locations at the respective bad major loop address locations. No modification of the data byte is required for bytes at major loop addresses where faulty bits are not present and thus a large number of "don't care" bits may exist in the correction bit bubble chip 28.

Bit 3 at major loop address 1 shows a binary 1 and the correction bit is also a binary 1. Bit 5 at address 2 shows a binary 0 which is corrected to be a binary 1 using a correction bit from the correction bit chip 28. Bit 5 at address 252 shows a binary 1 which is corrected to be a binary 0 using a correction bit from chip 28. Bit 7 at address 254 shows a binary 0 corrected, coincidentally, to be a binary 0. Note that the correction bit may or may not be the same as the faulty bit from the particular bubble memory chip 12 to 26. Thus whilst the veracity of the error bit cannot be trusted the correction bit is known to be correct.

For writing into the bubble memory device, the sequence of operations as shown in Figure 1 is merely reversed. The same PROM 74 is used to designate which bits need to be written into the correction bit chip 28 instead of, or alternatively in addition to, the normal bubble loop chip. The bubble memory device 10 has the very distinct advantage that no extra minor loops are required in the bubble memory chips to provide redundancy such as used in the prior art. When extra minor loops are required in addition to normal memory size, comparatively complex methods and hardware are needed to ensure synchronisation of the output of a word or byte organised memory and such systems require data deskewing or buffering techniques in order to provide for proper data flow. The present invention automatically provides for bit synchronisation and comparatively little additional hardware is required to implement the operation of the correction bit bubble memory chip 28.

The bubble memory device described above is such that a testing process for the bubble memory chips will produce a map or list of the defective major loop address locations for each chip and the bubble memory chips can be sorted so that the bubble memory chips comprising a byte or word of a memory may be selected so that no two or more bubble memory chips have defective bits in the same major loop address positions. Each bubble memory chip need only have the number of major loop bit locations as required to maintain the nominal memory size.

The above described bubble memory device has many advantages over the type of fault tolerant bubble memory device as shown in U.S. Patent Specification No. 3 909 810 in that the bubble memory device is not required to serve as a flag chip containing only information about defective byte locations. The above described bubble memory device uses only bubble memory chips for storage of data.  The defective map memory device or flaw table, as it is sometimes called, of the present bubble memory chip is contained in the PROM 74.  Similarly, the above described bubble memory device has advantages over systems involving extra or redundant minor loops in bubble memory devices because such systems require some type of mechanism for compacting data or buffering data in order to compensate for interruptions in the regular flow of data from a bubble memory when a bit location is skipped as the device is read in a serial fashion.

CLAIMS

1.    A bubble memory device characterised by comprising:
a plurality of bubble memory chips (12-26) equivalent in
number to a given word size;  a correction bit bubble memory
chip (28), memory means (74) responsive to input addresses
for identifying defective bit locations in said plurality of
bubble memory chips;  means (70) for providing addresses to
said memory means;  and substituting means (78) for substituting
in reading and writing operations, correction bits from said
correction bit bubble memory chip for bits in any one of said
plurality of bubble memory chips in response to output signals
from said memory means identifying a defective bit location.

2.    A bubble memory device as claimed in claim 1 characterised
in that said substituting means comprises a decoder (78)
associated with an output address from said memory means (74)
for identifying a particular one of said plurality of bubble
memory chips having a defective location and logic gate means
(48-62) which in response to a signal from said decoder connects
said correction bit chip with the appropriate input or output
of said memory device in reading and writing operations.

3.    A bubble memory device as claimed in claim 2 characterised
in that said logic gate means is composed of AND gates.

4.    A bubble memory device as claimed in claim 3 characterised
in that each of said AND gates is connected to receive a common
data bit input from said correction bit bubble memory chip (28)
and a unique input from said decoder (78) for gating said input
in response to an enable signal from said decoder, further AND
gate means (80-86) being provided for disabling the output from
any one of said bubble memory chips in response to an inverted
enable signal from said decoder when a bit from said correction bit chip is to be gated. '

5.    A bubble memory device as claimed in claim 4 characterised
by including means (76) for disabling said decoder when no
correction bit is to be gated.

FIG. 1

I = LOGICAL INVERTER

CORRECTION BITS FROM THIS CHIP

PROM MEMORY 256 × 4

DECODER 3/8

ADDRESS REGISTER

ENABLE DECODE LINE

BIT 0 OF BYTE
BIT 1
BIT 2
BIT 3
BIT 4
BIT 5
BIT 6
BIT 7

1/2

0029304

2/2

MAJOR LOOP ADDRESS

| 255 | 254 | 253 | 252 | | | 5 | 4 | 3 | 2 | 1 | 0 | | | | | |
|---|---|---|---|---|---|---|---|---|---|---|---|---|---|---|---|---|
| 1 | 1 | 0 | 1 | | | 0 | 1 | 0 | 1 | 1 | 0 | B | 1 | T | 0 | BUBBLE |
| 1 | 0 | 1 | 1 | | | 1 | 1 | 0 | 1 | 1 | 1 | B | 1 | T | 1 | |
| 0 | 0 | 0 | 1 | | | 0 | 0 | 1 | 0 | 1 | 1 | B | 1 | T | 2 | |
| 1 | 0 | 1 | 0 | | | 0 | 1 | 0 | 1 | [1] | 0 | B | 1 | T | 3 | |
| 1 | 1 | 0 | 1 | | | 1 | 1 | 1 | 0 | 1 | 0 | B | 1 | T | 4 | |
| 0 | 0 | 0 | [1] | | | 1 | 0 | 1 | [0] | 1 | 1 | B | 1 | T | 5 | |
| 0 | 1 | 0 | 1 | | | 0 | 1 | 1 | 0 | 1 | 0 | B | 1 | T | 6 | |
| 1 | [0] | 1 | 1 | | | 0 | 1 | 0 | 1 | 0 | 1 | B | 1 | T | 7 | |
| X | 0 | X | 0 | | | X | X | X | 1 | 1 | X | CORRECTION BIT | | | | |
| X | 1 | X | 1 | | | X | X | X | 1 | 1 | X | B | 1 | T | 0 | PROM |
| X | 1 | X | 0 | | | X | X | X | 0 | 1 | X | B | 1 | T | 1 | DECODER |
| X | 1 | X | 1 | | | X | X | X | 1 | 0 | X | B | 1 | T | 2 | INPUTS |
| 0 | 1 | 0 | 1 | | | 0 | 0 | 0 | 1 | 1 | 0 | B | 1 | T | 3 | ENABLE DECODE |

☐    DENOTES A BAD BIT LOCATION

✕    DENOTES A LOGICAL "DONT CARE" CONDITION, THE
     BIT MAY BE 1 OR 0 AND THE OPERATION WILL
     BE INDENTICAL.

FIG. 2